# EUROPÄISCHE PATENTSCHRIFT

(11) **EP 0 968 629 B1**
(45) Veröffentlichungstag und Bekanntmachung des Hinweises auf die Patenterteilung: **30.01.2002**
(21) Anmeldenummer: 98925391.9
(22) Anmeldetag: 13.03.1998
(51) Int. Cl.: H05K 3/00

(54) **FLACHBAUGRUPPE UND VERFAHREN ZUM NACHTRÄGLICHEN AUFBRINGEN VON ZUSATZBAUELEMENTEN AUF EINE LEITERPLATTE**
FLAT ASSEMBLY AND METHOD FOR POST-ASSEMBLING ADDITIONAL COMPONENTS ON A PRINTED CIRCUIT BOARD
MODULE PLAT ET PROCEDE DE MONTAGE ULTERIEUR DE COMPOSANTS SUPPLEMENTAIRES SUR UNE CARTE IMPRIMEE

(30) Priorität: 13.03.1997 DE 19710477
(43) Veröffentlichungstag der Anmeldung: 05.01.2000
(73) Patentinhaber: SIEMENS AKTIENGESELLSCHAFT, 80333 München (DE)
(72) Erfinder: LUDWIG, Gunter, D-90592 Schwarzenbruck (DE)
(86) Internationale Anmeldenummer: DE9800760
(87) Internationale Veröffentlichungsnummer: WO9841069

(56) Entgegenhaltungen:
- DE-A- 3 521 752
- DE-A- 3 817 267
- US-A- 4 696 105
- PATENT ABSTRACTS OF JAPAN vol. 10, no. 184 (E-415), 27. Juni 1986 & JP 61 032450 A (TOSHIBA CORP), 15. Februar 1986
- PATENT ABSTRACTS OF JAPAN vol. 8, no. 91 (E-241), 26. April 1984 & JP 59 011658 A (HITACHI SEISAKUSHO KK), 21. Januar 1984

## Beschreibung

Die Erfindung betrifft eine Flachbaugruppe nach dem Oberbegriff von Anspruch 1 und ein Verfahren zum nachträglichen Aufbringen von Zusatzbauelementen auf eine Flachbaugruppe. Auch bei Flachbaugruppen, die aus vollständig bestückten und im Lötbad fertig gelöteten Leiterplatten bestehen und die zum Beispiel für Steuergeräte in der Automobiltechnik eingesetzt werden, kommt es vor, daß nachträglich Zusatzbauelemente auf der Leiterplatte montiert und aufgelötet werden müssen. Ein Beispiel sind Abgleichswiderstände für zweipolige, bedrahtete Bauelemente auf der Leiterplatte.

Eine bekannte doppelseitig mit Leiterbahnen belegte Leiterplatte ist mit zumindest mit einem Bauelement versehen, das über seine Anschlußkappen mit Leiterbahnen auf einer Leiterplattenoberfläche verlötet ist. Es weist Anschlußelektroden auf, die durch nicht durchkontaktierte Bohrungen der Leiterplatte hindurch gesteckt und mit Leiterbahnen auf der anderen Leiterplattenoberfläche verlötet. Das Bauelement ist automatisch bestückt und verlötet (DE 35 21 752 A1). Muß eine solche Leiterplatte nachträglich mit einem Abgleichswiderstand o.ä. versehen werden, so ist es aus der betrieblichen Praxis bekannt, das Zusatzbauelemente nachträglich auf Lötstützpunkte aufzulöten. Solche Lötstützpunkte sind üblicherweise handbestückt und mit der Leiterplatte verlötet. Diese Arbeitsweise ist aufwendig.

Der Erfindung liegt die Aufgabe zugrunde, das nachträgliche Bestücken von Leiterplatten mit Zusatzbauelementen zu vereinfachen.

Die Aufgabe wird durch eine Flachbaugruppe nach Anspruch 1 und durch ein Verfahren nach Anspruch 5 gelöst. Zweckmäßige Weiterbildungen der Erfindung sind in den Unteransprüchen niedergelegt.

Ein Ausführungsbeispiel der Erfindung wird im folgenden anhand der Zeichnungen erläutert. Es zeigen:
- Figur 1: eine erfindungsgemäße Flachbaugruppe in einer Schnittansicht und
- Figur 2: einen Ausschnitt der Leiterplatte nach Figur 1 in einer Teilansicht von oben.

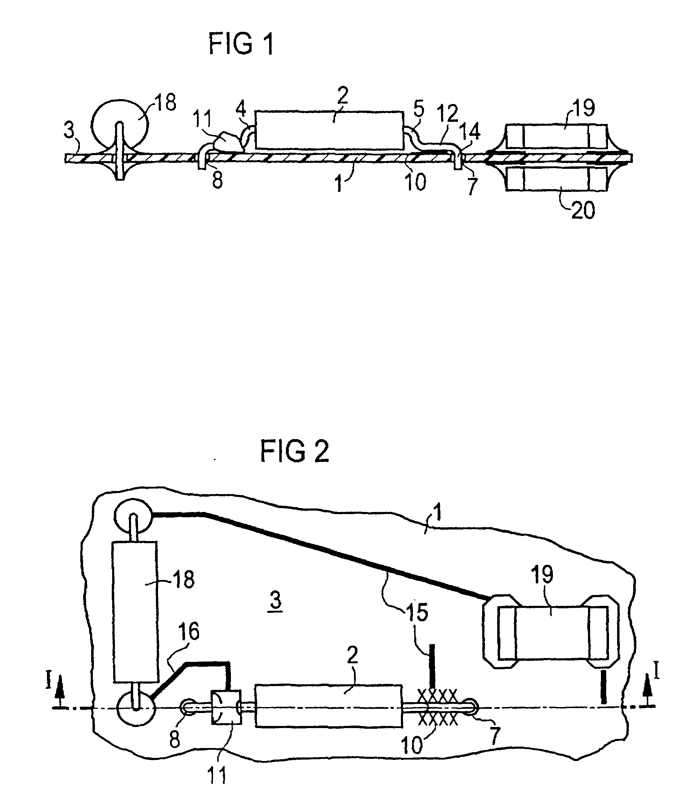

Eine Flachbaugruppe ist als eine mit Bauelementen, die weiter hinten im einzelnen aufgeführt werden, bestückte und fertig verlötete Leiterplatte 1 ausgebildet (Figuren 1 und 2). Auf der Leiterplatte 1 ist nachträglich ein Zusatzbauelement 2 montiert und verlötet worden, bei dem es sich beispielsweise um einen Abgleichswiderstand handelt, der aus unterschiedlichen Gründen nachträglich erforderlich geworden ist. Das Zusatzbauelement 2 ist auf die obere Leiterplattenoberfläche 3 montiert, und es weist zwei Anschlußdrähte 4 und 5 auf, durch die es mit der Leiterplatte 1 verbunden ist.

Die Leiterplatte 1 weist zwei durchgehende Bohrungen 7 und 8 auf, die entsprechend dem Bauelementeraster der Leiterplatte angeordnet sind. Diese Bohrungen 7, 8 sind lotfrei, d.h. sie weisen keine Durchkontaktierungen und keine Lötaugen auf. Dadurch wird vermieden, daß sie beim Löten, z.B. beim Schwallöten, der Leiterplatte mit Lötzinn verschlossen werden. Die Bohrungen 7, 8 dienen als Fixierbohrungen für das Zusatzbauelement 2. Während des nachträglichen Lötens des Zusatzbauelements 2 von Hand fixieren sie seine Lage und geben ihm den notwendigen Halt.

Auf der Leiterplattenoberfläche sind in der Nähe der Bohrungen 7 und 8 zwei Lötpads oder Lötflecken 10 und 11 vorgesehen. Sie liegen auf einer gedachten Verbindungslinie zwischen den beiden Bohrungen 7 und 8 und jeweils in der Nähe einer der Bohrungen, sie müssen aber ausreichend weit beabstandet, d. h. von ihr entfernt sein, damit beim Handlöten von der Oberseite der Leiterplatte her ein unkontrolliertes Durchfließen des Lötzinns durch die Bohrungen 7, 8, das zu einer Zapfen- oder Tropfenbildung am Anschlußdrahtende unterhalb der Leiterplatte 1 führen könnte, vermieden wird. Andernfalls bestünde eine Kurzschlußgefahr, zum Beispiel an einem umgebenden Gehäuse, oder es wäre eine Nachbearbeitung der Lötstellen erforderlich. In der Zeichnung ist der Lötpad 10 in ungelötetem und der Lötpad 11 in gelötetem Zustand dargestellt.

Die Anschlußdrähte 4 und 5 des Zusatzbauelements 2 sind so gebogen, daß sie jeweils einen ersten Bereich 12, der in etwa parallel zu der Leiterplattenoberfläche 3 verläuft, und einen zweiten Bereich 14, der in etwa senkrecht zu der Leiterplattenoberfläche 3 verläuft, aufweisen.

Nachdem ein erforderlicher elektrischer Abgleichswiderstandswert für ein oder mehrere Bauelemente auf der Leiterplatte ermittelt worden ist, wird ein Zusatzbauelement 2 in Gestalt eines Abgleichswiderstandes mit dem erforderlichen Widerstandswert ausgewählt und von der Oberseite der Leiterplatte 1 aus mit seinen Anschlußdrähten 4 und 5 in die Bohrungen 7 und 8 eingesetzt. Damit ist er in seiner Lage zuverlässig fixiert.

Danach werden die ersten Bereiche 12 der Anschlußdrähte 4 und 5, die so ausgebildet sind, daß sie auf den Lötpads 10 bzw. 11 aufliegen, mittels eines Weichlots von oben aus mit den Lötpads 10 und 11 verlötet. Über diese Lötverbindungen wird das Zusatzbauelement 2 zum einen auf der Leiterplatte 1 mechanisch befestigt und zum anderen elektrisch mit der Leiterplatte verbunden. Die elektrische Kontaktierung erfolgt über auf der Leiterplatte 11 vorhandene Leiterbahnen 15 und 16 (Figur 2), die mit den Lötpads 10 und 11 verbunden sind. Wie bereits erwähnt, ist der Lötpad 10 im dem Zustand vor dem Löten angedeutet und der Lötpad 11 nach dem Lötvorgang dargestellt.

Das Bauelement 2 ist über seinen Anschlußdraht 5 und den-dann verlöteten - Lötpad 10 mit einer ersten Leiterbahn 15 und über seinen Anschlußdraht 4 und den Lötpad 11 mit einer zweiten Leiterbahn 16 verbunden. Diese Leiterbahnen sind hier nur als schematisches Beispiel dargestellt.

Die Leiterplatte 1 der fertigen Flachbaugruppe ist - vor dem Abgleichen mit dem Zusatzbauelement - bereits mit folgenden Bauelementen bestückt: ein schwallgelötetes bedrahtetes Bauelement 18, ein reflowgelötetes SMD-Bauelement 19 und ein schwall- oder reflowgelötetes SMD-Bauelement 20. Auch diese Bauelemente sind nur als Beispiele aufgeführt.

## Patentansprüche

1. Elektronische Flachbaugruppe bestehend aus einer Leiterplatte (1), die mit Bauelementen (18 - 20) bestückt ist, die auf die Leiterplatte (1) in einem Lötbad aufgelötet sind, **dadurch gekennzeichnet,**
- **daß** die Leiterplatte (1) zwei von Durchkontaktierungen und Lötaugen freie Fixierbohrungen (7, 8) aufweist, in die die Enden von Anschlußdrähten (4, 5) eines Zusatzbauelements (2) eingesteckt sind,
- **daß** die Anschlußdrähte (4, 5) des Zusatzbauelements (2) je einen in etwa parallel zu der Leiterplattenoberfläche (3) verlaufenden ersten Bereich (12) und einen in Richtung der Fixierbohrungen (7, 8) umgebogenen zweiten Bereich (14) aufweisen, und
- **daß** auf der Leiterplatte (1) zwischen den beiden Fixierbohrungen (7, 8) zwei von den Fixierbohrungen beabstandete Lötpads (10, 11) aufgebracht sind, mit denen das Zusatzbauelement (2) auf der fertig bestückten und verlöteten Leiterplatte (1) befestigt und elektrisch mit ihr verbunden ist.

2. Flachbaugruppe nach Anspruch 1, **dadurch gekennzeichnet, daß** das Zusatzbauelement (2) ein passives Bauelement, insbesondere ein Abgleichswiderstand für ein mit der Leiterplatte (1) verlötetes zweipoliges elektronisches Bauelement, ist.

3. Flachbaugruppe nach einem der vorhergehenden Ansprüche, **dadurch gekennzeichnet, daß** der parallel zu der Leiterplattenoberfläche verlaufenden Bereich (12) der Anschlußdrähte (4, 5) mittels Weichlot mit je einem der Lötpads (10, 11) verlötet ist.

4. Flachbaugruppe nach einem der vorhergehenden Ansprüche, **dadurch gekennzeichnet, daß** die Fixierbohrungen (7, 8) im Bauelementeraster auf der Leiterplatte angeordnet sind.

5. Verfahren zum nachträglichen Aufbringen von Zusatzbauelementen auf eine Flachbaugruppe im Gestalt einer Leiterplatte, die mit Bauelementen automatisch bestückt und verlötet ist,
- bei dem Anschlußdrähte des Zusatzbauelements so gebogen werden, daß sie je einen ersten, in etwa parallel zu der Leiterplattenoberfläche verlaufenden Bereich und einen zweiten, in etwa senkrecht zu der Leiterplattenoberfläche verlaufenden Bereich aufweisen,
- bei dem das Zusatzbauelement mit den senkrecht zu der Leiterplattenoberfläche verlaufenden Bereichen ihrer Anschlußdrähte in zwei von Durchkontaktierungen und Lötaugen freie Fixierbohrungen der Leiterplatte fixiert wird, und
- bei dem das Zusatzbauelement mit den parallel zu der Leiterplattenoberfläche verlaufenden Bereichen ihrer Anschlußdrähte auf zwei auf der Oberfläche der Leiterplatte vorhandene, von den Fixierbohrungen beabstandete Lötpads aufgelötet wird.

6. Verfahren nach Anspruch 5 , **dadurch gekennzeichnet, daß** die Anschlußdrähte mittels einem Weichlot von oben her mit den Lötpads verlötet werden.

7. Verfahren nach Anspruch 5 oder 6, **dadurch gekennzeichnet, daß** durch das Löten das Zusatzbauelement auf der Leiterplatte befestigt und mit ihr elektrisch verbunden wird.

## Claims

1. Electronic printed circuit board consisting of a circuit board (1), fitted with components (18 - 20) that are soldered to the circuit board (1) in a solder bath, **characterised in that**,
- the circuit board (1) has two fixing holes (7, 8), that are not through-plated and have no soldering lugs, into which the ends of the terminal wires (4, 5) of an additional component (2) are inserted,
- that the terminal wires (4, 5) of the additional component (2) each have a first area (12) running approximately parallel to the circuit board surface (3) and a second area (14) bent in the direction of the fixing holes (7, 8), and
- that on the circuit board (1) between the two fixing holes (7, 8) two solder pads (10, 11) are fitted a distance from the fixing holes, by means of which the additional component (2) is secured to the completely fitted and soldered circuit board (1) and electrically connected to it.

2. Printed circuit board in accordance with Claim 1, **characterised in that** the additional component (2) is a passive component, particularly a trimming resistor for a two-pole electronic component soldered to the circuit board (1).

3. Printed circuit board in accordance with one of the preceding claims, **characterised in that** the area (12) of the terminal wires (4, 5) which runs parallel to the circuit board surface is soldered to one of the solder pads (10, 11) by means of soft solder.

4. Printed circuit board in accordance with one of the preceding claims, **characterised in that** the fixing holes (7, 8) are arranged on the circuit board in the component grid.

5. Method for retrospective fitting of additional components to a printed circuit board, designed as a circuit board that is automatically fitted with components and soldered,
- whereby the terminal wires of the additional component are bent such that they each have a first area running approximately parallel to the circuit board surface and a second area running approximately vertical to the circuit board surface,
- whereby the additional component is fixed in two fixing holes of the circuit board that are not through-plated and have no soldering lugs, by means of the areas of its terminal wires running vertical to the circuit board surface, and
- whereby the additional component is soldered to two solder pads on the surface of the circuit board a distance from the fixing holes, by means of the areas of its terminal wires running parallel to the surface of the circuit board.

6. Method in accordance with Claim 5, **characterised in that** the terminal wires are soldered from above to the solder pads by soft solder.

7. Method in accordance with Claim 5 or 6, **characterised in that** by means of the soldering the additional component is secured to the circuit board and electrically connected to it.

## Revendications

1. Module plat électronique consistant en une plaquette de circuit imprimé (1), qui est équipée de composants (18 - 20), qui sont brasés sur la plaquette de circuit imprimé (1) dans un bain de brasage, **caractérisé en ce que**
- la plaquette de circuit imprimé (1) comporte deux trous de fixation (7, 8) exempts de contact de passage et de douilles de brasage, dans lesquels sont enfichées les extrémités de fils de raccordement (4, 5) d'un composant supplémentaire (2),
- **en ce que** les fils de raccordement (4, 5) du composant supplémentaire (2) comportent chacun un premier tronçon (12) sensiblement parallèle à la surface (3) de la plaquette de circuit imprimé et un deuxième tronçon (14) courbé en direction des trous de fixation (7, 8), et
- **en ce que**, sur la plaquette de circuit imprimé (1) entre les deux trous de fixation (7, 8), sont placées des plages de brasage (10, 11) à distance des trous de fixation, par lesquels le composant supplémentaire (2) est fixé sur la plaquette de circuit imprimé (1) équipée complètement et brasée et leur est relié électriquement.

2. Module plat selon la revendication 1, **caractérisé en ce que** le composant supplémentaire (2) est un composant passif, en particulier une résistance d'ajustement pour un composant électronique bipolaire brasé sur la plaquette de circuit imprimé (1).

3. Module plat selon l'une des revendications précédentes, **caractérisé en ce que** le tronçon 12, parallèle à la surface de la plaquette de circuit imprimé, des deux fils de raccordement (4, 5) est brasé respectivement à l'aide d'une brasure tendre avec chacun des plages de brasage respectives(10, 11).

4. Module plat selon l'une des revendications précédentes, **caractérisé en ce que** les trous de fixation (7, 8) sont disposés selon la matrice de montage des composants sur la plaquette de circuit imprimé.

5. Procédé pour la mise en place ultérieure de composants supplémentaires sur un module plat ayant la forme d'une plaquette de circuit imprimé, qui est équipée et brasée automatiquement avec des composants,
- dans lequel les fils de raccordement du composant supplémentaire sont courbés de manière que chacun d'eux comporte un premier tronçon sensiblement parallèle à la surface de la plaquette de circuit imprimé et un deuxième tronçon sensiblement perpendiculaire à la surface de la plaquette de circuit imprimé,
- dans lequel le composant supplémentaire est fixé par les tronçons perpendiculaires à la surface de la plaquette de circuit imprimé de ses fils de raccordement dans deux trous de fixation de la plaquette de circuit imprimé exempts de contact de passage et de douilles de brasure, et
- dans lequel le composant supplémentaire est brasé avec les tronçons parallèles à la surface de la plaquette de circuit imprimé de ses fils de raccordement sur deux plages de brasure existant sur la surface de la plaquette de circuit imprimé et éloignées des trous de fixation.

6. Procédé selon la revendication 5, **caractérisé en ce que** les fils de raccordement sont brasés au moyen d'une brasure tendre à partir du haut avec la plage de brasure.

7. Procédé selon la revendication 5 ou 6, **caractérisé en ce que** le composant supplémentaire est fixé sur la plaquette de circuit imprimé et relié électriquement à celle-ci par le brasage.
